# EUROPEAN PATENT APPLICATION

(11) **EP 4 224 363 A1**
(43) Date of publication of application: **09.08.2023**
(21) Application number: 21891029.7
(22) Date of filing: 04.11.2021
(51) Int. Cl.: G06K 9/00

(54) **ELECTRONIC DEVICE**

(30) Priority: 12.11.2020 CN 202011262385
(71) Applicant: Huawei Technologies Co., Ltd., Shenzhen, Guangdong 518129 (CN)
(72) Inventor: ZHOU, Yidan, Shenzhen, Guangdong 518129 (CN); LU, Yuewan, Shenzhen, Guangdong 518129 (CN); DONG, Chen, Shenzhen, Guangdong 518129 (CN); GAO, Wenmei, Shenzhen, Guangdong 518129 (CN)
(74) Representative: MERH-IP Matias Erny Reichl Hoffmann Patentanwälte PartG mbB
(86) International application number: PCT/CN2021/128596
(87) International publication number: WO 2022/100502

(57) **Abstract**

Embodiments of this application provide an electronic device. The electronic device includes a display panel, a camera, a fingerprint recognition light source, and a light steering element; in the display panel, transmittance of a first display area is greater than transmittance of a second display area, and the second display area includes a fingerprint recognition area; the camera, the fingerprint recognition light source, and the light steering element are all located on a side of the display panel that is back onto a light outlet surface of the display panel, where the camera includes an optical-to-electrical conversion chip, and the camera is disposed on a side of the first display area that is back onto a light outlet surface of the first display area; the fingerprint recognition light source is configured to emit light to the fingerprint recognition area in a fingerprint recognition phase; and the light steering element is configured to transfer light reflected by a touch body that presses the fingerprint recognition area to the optical-to-electrical conversion chip in the fingerprint recognition phase. In the fingerprint recognition phase, fingerprint image information can be collected by using an optical-to-electrical conversion chip of the camera, so as to implement fingerprint recognition. The optical-to-electrical conversion chip in the camera has relatively high imaging quality and precision, so that accuracy of fingerprint recognition can be improved.

## Description

This application claims priority to Chinese Patent Application No. 202011262385.0, filed with the China National Intellectual Property Administration on November 12, 2020 and entitled "ELECTRONIC DEVICE", which is incorporated herein by reference in its entirety.

### TECHNICAL FIELD

This application relates to the field of display technologies, and more specifically, to an electronic device.

### BACKGROUND

With increasingly high requirements on a screen-to-body ratio of electronic display products, a concept of bezel-less screen emerges. For an electronic product having a fingerprint recognition function, a capacitive chip needs to be disposed in a conventional capacitive fingerprint recognition solution, and disposing a fingerprint capacitive chip on a front side of the electronic product affects a screen-to-body ratio thereof. Therefore, to improve the screen-to-body ratio and implement the bezel-less screen, all current mainstream products use an under-screen fingerprint recognition technology.

Under-screen fingerprint recognition mainly uses a light reflection principle. When a finger presses on a fingerprint recognition area of a screen, light emitted by a fingerprint recognition light source illuminates an entire surface of the finger. The light is reflected by the finger and then enters the screen again. Finally, the light is emitted to an optical-to-electrical conversion element at the bottom of the screen. The optical-to-electrical conversion element collects a fingerprint image to implement fingerprint recognition. However, in a current under-screen optical fingerprint recognition solution, there is still a problem that accuracy of fingerprint recognition is relatively low and user experience is affected.

### SUMMARY

In view of this, this application provides an electronic device, to resolve a technical problem in the conventional technology that accuracy of fingerprint recognition is relatively low.

An embodiment of this application provides an electronic device, where the electronic device includes a display panel, a camera, a fingerprint recognition light source, and a light steering element. The display panel includes a first display area and a second display area, transmittance of the first display area is greater than transmittance of the second display area, and the second display area includes a fingerprint recognition area.

The camera, the fingerprint recognition light source, and the light steering element are all located on a side of the display panel that is back onto a light outlet surface of the display panel.

The camera includes an optical-to-electrical conversion chip, and the camera is disposed on a side of the first display area that is back onto a light outlet surface of the first display area.

The fingerprint recognition light source is configured to emit light to the fingerprint recognition area in a fingerprint recognition phase.

The light steering element is configured to transfer light reflected by a touch body that presses the fingerprint recognition area to the optical-to-electrical conversion chip in the fingerprint recognition phase.

In the electronic device provided in this embodiment of this application, the camera is disposed on a side of the first display area that is back onto the light outlet surface of the first display area, so that an under-screen camera solution is implemented. The light steering element is disposed below the display panel, and the light steering element can transfer the light reflected by a touch body in the fingerprint recognition area to the optical-to-electrical conversion chip of the camera. In this way, in the fingerprint recognition phase, the optical-to-electrical conversion chip in the camera can receive fingerprint detection light used for fingerprint recognition, so that fingerprint image information is collected by using the optical-to-electrical conversion chip in the camera, so as to implement the fingerprint recognition. The optical-to-electrical conversion chip in the camera lias relatively high imaging quality and precision, so that accuracy of fingerprint recognition can be improved. In addition, in this embodiment of this application, the optical-to-electrical conversion chip in the camera can be separately applied in a phase in which the camera is invoked to perform photographing and a phase in which the fingerprint recognition is performed, so that hardware integration is improved. An optical-to-electrical conversion chip used for fingerprint recognition does not need to be additionally disposed, so that costs can be reduced.

Further, the electronic device further includes a fingerprint processing module, a photographing processing module, and a switching control module, where the switching control module is configured to control the fingerprint processing module to be electrically connected to the optical-to-electrical conversion chip in response to the electronic device working in the fingerprint recognition phase; the switching control module is further configured to control the photographing processing module to be electrically connected to the optical-to-electrical conversion chip in response to the electronic device working in a phase of invoking the camera to perform photographing; the fingerprint processing module is configured to receive image information obtained after the optical-to-electrical conversion chip receives light, and perform fingerprint recognition; and the photographing processing module is configured to receive the image information obtained after the optical-to-electrical conversion chip receives light, and perform imaging on a photographed object.

In an actual application, the switching control module is connected to an application processor chip of the electronic device, the application processor chip sends a control signal to the switching control module, and the switching control module determines a working state of the electronic device based on the received control chip, so as to control the fingerprint processing module to be electrically connected to the optical-to-electrical conversion chip, or control the photographing processing module to be electrically connected to the optical-to-electrical conversion chip based on the working state of the electronic device. In this way, the optical-to-electrical conversion chip can be applied when the electronic device works in different working states.

Specifically, the fingerprint processing module includes an obtaining unit and a processor, where in a fingerprint recognition process, the obtaining unit is configured to: when the fingerprint recognition light source is turned on, obtain a first image based on an optical signal collected by the optical-to-electrical conversion chip, and send the first image to the processor, where the first image includes fingerprint image information and background image information; and when the fingerprint recognition light source is turned off, obtain a second image based on an optical signal collected by the optical-to-electrical conversion chip, and send the second image to the processor, where the second image includes background image information; and the processor is configured to perform differential processing on the first image and the second image to obtain a fingerprint image.

When fingerprint recognition is performed once, the fingerprint recognition light source is controlled to be turned on and turned off once. When the fingerprint recognition light source is turned on, the optical-to-electrical conversion chip receives the fingerprint detection light transmitted to the optical-to-electrical conversion chip by using the light steering element and the ambient light that is transmitted to the optical-to-electrical conversion chip after penetrating the first display area, so the image information collected by the optical-to-electrical conversion chip includes the fingerprint image information and the background image information. When the fingerprint recognition light source is turned off, the optical-to-electrical conversion chip receives only the ambient light that penetrates the first display area and is then emitted to the optical-to-electrical conversion chip, so the image signal collected by the optical-to-electrical conversion chip includes only the background image information. Differential processing is performed on the first image and the second image to obtain the fingerprint image, so that interference caused by ambient light to fingerprint detection can be eliminated, and accuracy of fingerprint recognition can be improved.

Specifically, the camera further includes a lens group, and the lens group is located on a side of the optical-to-electrical conversion chip that is close to the display panel. The lens group has a function of converging light, and the fingerprint detection light emitted by the light steering element can be converged on the optical-to-electrical conversion chip after being processed by the lens group, thereby reducing a light loss and ensuring light utilization.

Specifically, the light steering element and the lens group are disposed in a staggered manner. When the camera is invoked to perform imaging, the light steering element is prevented from blocking the light emitted to the camera after the light penetrates the first display area, which ensures that imaging performance is not affected.

Further, the light steering element is located between the fingerprint recognition area and the first display area. Specifically, the light steering element includes a light inlet side and a light outlet side, the light inlet side is close to the fingerprint recognition area, and the light outlet side is close to the camera. In this way, it is ensured that the light reflected by the touch body in the fingerprint recognition area in the fingerprint recognition phase can enter the light steering element, and the light is transferred to the optical-to-electrical conversion chip in the camera by using the light steering element.

In an embodiment, the light steering element includes a first reflective part and a second reflective part that are disposed opposite to each other, surfaces of the first reflective part and the second reflective part that are opposite to each other are reflective surfaces, the second reflective part is on a side of the first reflective part that is away from the display panel, and there is a certain distance between the reflective surface of the first reflective part and the reflective surface of the second reflective part. Optionally, a medium between the first reflective part and the second reflective part is air. In this implementation, the first reflective part and the second reflective part are disposed, which can ensure that after entering the light steering element, the light is reflected and propagated multiple times on the reflective surface of the first reflective part and the reflective surface of the second reflective part, so as to transfer the light to the optical-to-electrical conversion chip of the camera.

Further, at one end close to the fingerprint recognition area, the second reflective part extends out of an edge of the first reflective part, so that the reflective surface of the second reflective part can conveniently receive the light reflected by the touch body in the fingerprint recognition area, and it is ensured that the fingerprint detection light that is reflected by the touch body and used for fingerprint recognition can be emitted into the light steering element, so as to reduce loss of the fingerprint detection light. At one end close to the first display area, the first reflective part extends out of an edge of the second reflective part, so that it is ensured that the light can be emitted to the optical-to-electrical conversion chip after being processed by the light steering element, so as to improve the efficiency of transferring fingerprint detection light by the light steering element.

In another embodiment, the light steering element is an optical waveguide, and the optical waveguide includes a light inlet surface and a light outlet surface, where the light inlet surface is located at one end that is close to the fingerprint recognition area, and the light inlet surface faces the fingerprint recognition area; and the light outlet surface is located at one end that is close to the first display area, and the light outlet surface faces the optical-to-electrical conversion chip. The optical waveguide is used as an overall structure, so the optical waveguide is more stable in structure, performance of transferring light by the optical waveguide is more reliable, and a light loss of light transmitted in the optical waveguide is small, so as to ensure that a light amount of fingerprint detection light received by the optical-to-electrical conversion chip is large enough, thereby ensuring accuracy of fingerprint detection.

Specifically, the display panel includes a substrate and a light emitting device layer, and the light emitting device layer is located on a side of the substrate that is away from the camera, where the light emitting device layer includes a plurality of light emitting devices; and a density of the light emitting devices in the first display area is less than a density of the light emitting devices in the second display area. In this implementation, the disposing density of the light emitting devices in the first display area is reduced, so as to improve the transmittance of the first display area, thereby ensuring an imaging effect when the camera is invoked to perform photographing.

The electronic device provided in this application has the following beneficial effects: A light steering element is disposed on a side of a display panel that is back onto a light outlet surface, and the light steering element can transfer light reflected by a touch body in a fingerprint recognition area to an optical-to-electrical conversion chip of a camera. In the fingerprint recognition phase, the optical-to-electrical conversion chip in the camera can receive fingerprint detection light used for fingerprint recognition, so that fingerprint image information is collected by using the optical-to-electrical conversion chip in the camera, so as to implement the fingerprint recognition. In this embodiment of this application, the optical-to-electrical conversion chip in the camera can be separately applied in a phase in which the camera is invoked to perform photographing and a phase in which the fingerprint recognition is performed, so that hardware integration is improved. An optical-to-electrical conversion chip used for fingerprint recognition does not need to be additionally disposed, so that costs can be reduced. In addition, the optical-to-electrical conversion chip in the camera has relatively high imaging quality and precision, so that accuracy of fingerprint recognition can be improved.

### BRIEF DESCRIPTION OF DRAWINGS

To describe the technical solutions in embodiments of the present invention or in the conventional technology more clearly, the following briefly describes the accompanying drawings used in describing embodiments or the conventional technology. It is clear that the accompanying drawings in the following description show some embodiments of the present invention, and persons of ordinary skill in the art may still derive other drawings from these accompanying drawings without creative efforts.
FIG. 1 is a schematic diagram of an under-screen fingerprint recognition solution in a related technology;
FIG. 2 is a schematic top view of an electronic device according to an embodiment of this application;
FIG. 3 is a schematic cross-sectional diagram across A-A' in FIG. 2;
FIG. 4 is another schematic cross-sectional diagram across B-B' in FIG. 2;
FIG. 5 is another schematic top view of an electronic device according to an embodiment of this application;
FIG. 6 is another schematic cross-sectional diagram across A-A' in FIG. 2;
FIG. 7 is another schematic cross-sectional diagram across A-A' in FIG. 2;
FIG. 8 is a flowchart of a fingerprint recognition method according to an embodiment of this application;
FIG. 9 is a flowchart of fingerprint recognition working of an electronic device according to an embodiment of this application; and
FIG. 10 is a schematic modular diagram of an electronic device according to an embodiment of this application.

### DESCRIPTION OF EMBODIMENTS

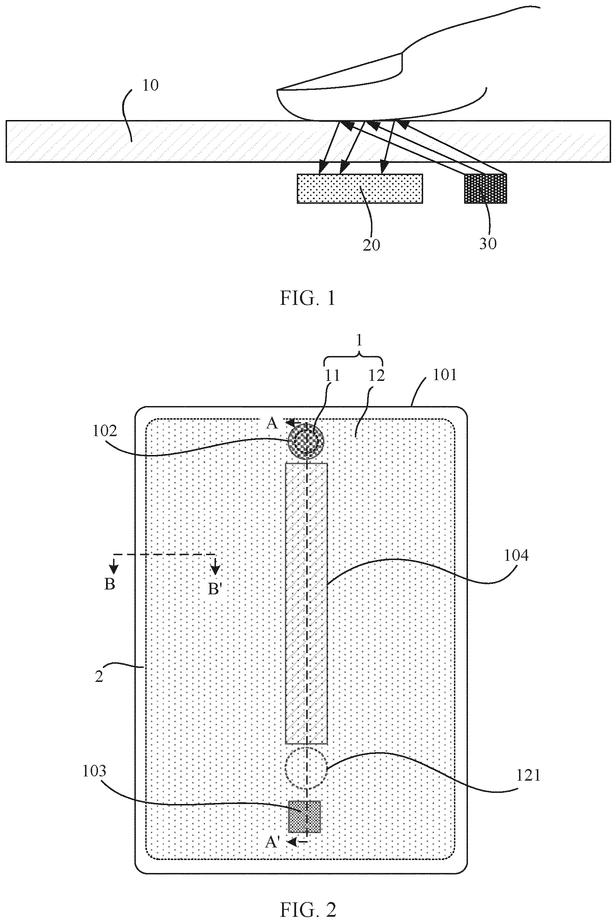

FIG. 1 is a schematic diagram of an under-screen fingerprint recognition solution. As shown in FIG. 1, a fingerprint optical-to-electrical conversion chip 20 and a fingerprint recognition light source 30 are disposed below a display area of a display panel 10. When a finger presses the fingerprint recognition area, light emitted by the fingerprint recognition light source 30 penetrates the display panel 10 and is reflected by the finger, and light reflected by the finger penetrates the display panel 10 again and is received by the fingerprint optical-to-electrical conversion chip 20. After the light that is emitted by the fingerprint recognition light source 30 illuminates to the finger, both a valley and a ridge of the fingerprint can reflect the light. However, an amount of the light reflected by the valley of the fingerprint is different from an amount of the light reflected by the ridge. Therefore, a light sensitive device in the fingerprint optical-to-electrical conversion chip 20 generates different semaphores after receiving the light reflected by the valley or the ridge of the fingerprint. In this way, the valley and the ridge of the fingerprint are recognized based on sizes of semaphores generated by the plurality of light sensitive devices, so that a fingerprint image is formed. In the optical fingerprint recognition technology, a corresponding fingerprint optical-to-electrical conversion chip needs to be disposed to receive light reflected by a fingerprint. FIG. 1 shows a solution in which the fingerprint optical-to-electrical conversion chip is disposed on a back side of a display panel. In the under-screen fingerprint recognition solution, light used for fingerprint recognition needs to penetrate the display panel twice before being received by the fingerprint optical-to-electrical conversion chip. However, transmittance of the display panel is limited. Therefore, an amount of light that can be received by the fingerprint optical-to-electrical conversion chip is limited. In a case that the amount of light that can be received by the fingerprint optical-to-electrical conversion chip is limited, the photosensitive performance and precision of the fingerprint optical-to-electrical conversion chip become main factors that affect accuracy of fingerprint recognition.

Based on this, an embodiment of this application provides an electronic device. The electronic device includes an under-screen camera, and an optical-to-electrical conversion chip in the under-screen camera is used to receive fingerprint detection light, so that fingerprint recognition can be implemented. Compared with a general fingerprint optical-to-electrical conversion chip, the optical-to-electrical conversion chip in the camera has a higher imaging quality and precision, so that the accuracy of fingerprint recognition can be improved. The following uses specific embodiments to describe this application in detail.

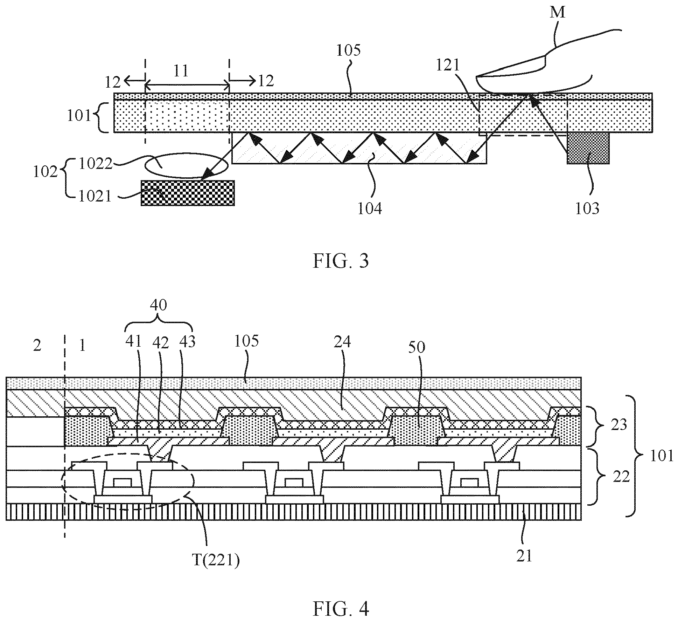

FIG. 2 is a schematic top view of an electronic device according to an embodiment of this application. FIG. 3 is a schematic cross-sectional diagram across A-A' in FIG. 2.

As shown in FIG. 2 and FIG. 3, the electronic device includes a display panel 101, a camera 102, a fingerprint recognition light source 103, and a light steering element 104. The display panel 101 includes a display area 1 and a non-display area 2, and the non-display area 2 is disposed around the display area 1. The display area 1 includes a first display area 11 and a second display area 12. Transmittance of the first display area 11 is greater than transmittance of the second display area 12. The transmittance herein is understood as transmittance per unit area. The second display area 12 includes a fingerprint recognition area 121. FIG. 3 further shows a protection cover 105 in the electronic device. The protection cover 105 is configured to protect the display panel 101.

The camera 102, the fingerprint recognition light source 103, and the light steering element 104 are all located on a back side of the display panel 101. The back side of the display panel 101 is understood as a side that is back onto a light outlet surface of the display panel 101.

The camera 102 is disposed on a side of the first display area 11 that is back onto a light outlet surface of the first display area 11. The camera includes an optical-to-electrical conversion chip 1021 and a lens group 1022 (shown as an example in the figure). The lens group 1022 is located on a side of the optical-to-electrical conversion chip 1021 that is close to the display panel 101. The lens group 1022 includes one or more lenses. Optionally, the lens group 1022 includes multiple stacked lenses, and different lens groups have different functions. For example, the lens group includes a focusing lens group, a zoom lens group, a compensation lens group, and the like. The optical-to-electrical conversion chip 1021 is a complementary metal oxide semiconductor (Complementary Metal Oxide Semiconductor, CMOS) chip, and the optical-to-electrical conversion chip 1021 includes a plurality of photosensitive devices arranged in an array. The photosensitive device has an optical-to-electrical conversion function, and is configured to convert an optical signal into an electrical signal after receiving light. In this embodiment of this application, the camera 102 is disposed on a side of the first display area 11 that is back onto the light outlet surface of the first display area 11, that is, the camera 102 is disposed below the display area 1, to implement an under-screen camera solution, so that a screen-to-body ratio can be improved. The camera 102 is used as a front-facing camera. In an application, when the camera is not invoked, the first display area 11 can normally display an image. When the camera needs to be invoked, the first display area 11 may be controlled not to display. After the ambient light penetrates the first display area 11, the ambient light is received by the optical-to-electrical conversion chip 1021 in the camera 102, and the optical-to-electrical conversion chip 1021 collects image information and then performs imaging. Transmittance of the first display area 11 is set to be greater than transmittance of the second display area 12, so that it is ensured that the camera 102 can receive plenty of ambient light in an application, and imaging quality of the camera 102 is ensured.

When the electronic device works in a fingerprint recognition phase, when a touch body (for example, a finger of a user) touching or pressing the fingerprint recognition area 121 is sensed, the fingerprint recognition light source 103 is controlled to be turned on. A pressure sensor may be disposed to sense an operation performed by the user on the fingerprint recognition area. When the finger of the user touches or presses, or the finger of the user is placed on the fingerprint recognition area, the finger of the user exerts a specific force on the display panel. The pressure sensor determines the operation performed by the user on the fingerprint area by sensing the force. After the fingerprint recognition light source 103 is turned on, light emitted by the fingerprint recognition light source 103 is emitted to the fingerprint recognition area 121, and the fingerprint recognition area 121 can be illuminated by the light emitted by the fingerprint recognition light source 103. For example, when fingerprint recognition detection is performed in a lock screen state or in another application scenario, after the fingerprint recognition light source 103 is turned on, light emitted by the fingerprint recognition light source 103 to the fingerprint recognition area 121 can be reflected by the finger of the user, and amounts of light reflected by a valley or a ridge of the fingerprint are different. Therefore, semaphores generated after the photosensitive device in the optical-to-electrical conversion chip 1021 receives the light reflected by the valley or the ridge of the fingerprint are different. The valley and the ridge of the fingerprint are recognized based on a difference between sizes of semaphores generated by a plurality of photosensitive devices, to form a fingerprint image, and fingerprint recognition detection is completed. A relative position between the fingerprint recognition light source 103 and the fingerprint recognition area 121 is merely an example in the figure. In an embodiment, the fingerprint recognition light source 103 may be located right below the fingerprint recognition area 121. In another embodiment, the fingerprint recognition light source 103 and the fingerprint recognition area 121 are disposed in a staggered manner, that is, when the electronic device is viewed from a top view angle, the fingerprint recognition light source 103 is located below the fingerprint recognition area obliquely. In an actual application, a relative position of the fingerprint recognition light source 103 and the fingerprint recognition area 121 may be properly designed based on a specific design requirement, and a design of a light emitting angle of the fingerprint recognition light source 103 is combined to ensure that light emitted by the fingerprint recognition light source 103 can be emitted to the fingerprint recognition area 121, so that when the finger of the user touches or presses the fingerprint recognition area 121 in the fingerprint recognition phase, the light can illuminate to the finger of the user.

The light steering element 104 is configured to transfer light reflected by a touch body that presses the fingerprint recognition area 121 to the optical-to-electrical conversion chip 1021 in the fingerprint recognition phase. As shown in an optical path diagram shown in FIG. 3, in the fingerprint recognition phase, after the fingerprint recognition light source 103 is turned on, light emitted by the fingerprint recognition light source 103 is emitted to the fingerprint recognition area 121, and the light penetrates the display panel 101 and is reflected by a touch body M that touches the fingerprint recognition area 121, and then is emitted back to the display panel 101. The light reflected by the touch body M is transferred to the optical-to-electrical conversion chip 1021 by using the light steering element 104, so as to collect fingerprint image information by using the optical-to-electrical conversion chip 1021 in the camera 102. Then the optical-to-electrical conversion chip 1021 sends the fingerprint image information to a fingerprint processing module, and the fingerprint processing module processes a fingerprint image signal, to implement fingerprint recognition. In other words, in this embodiment of this application, the optical-to-electrical conversion chip in the camera can obtain the image information of the photographed object when the camera is invoked, and the optical-to-electrical conversion chip in the camera can be further applied to the fingerprint recognition function to obtain the fingerprint image information.

In this embodiment of this application, the optical-to-electrical conversion chip is configured to receive fingerprint detection light transmitted to the electronic device by using a light steering element when the electronic device works in the fingerprint recognition phase, to collect the optical signal to obtain the fingerprint image information.

The optical-to-electrical conversion chip is further configured to receive light emitted by a photographed object when the electronic device works in a phase in which the camera is invoked to perform photographing, so as to collect the optical signal to obtain the image information of the photographed object. The photographed object can reflect or scatter ambient light. When the camera is invoked to perform photographing, the light reflected or scattered by a surface of the photographed object penetrates the first display area and is received by the optical-to-electrical conversion chip. The photographed object is equivalent to a light source, and the light emitted by the photographed object is understood as the light reflected or scattered on the surface of the photographed object.

Specifically, the electronic device provided in this embodiment of this application includes a fingerprint processing module, a photographing processing module, and a switching control module. The switching control module is configured to control the fingerprint processing module to be electrically connected to the optical-to-electrical conversion chip in response to the electronic device working in the fingerprint recognition phase, so that the fingerprint processing module receives an optical signal collected by the optical-to-electrical conversion chip, and processes the optical signal to obtain fingerprint image information. The switching control module is further configured to control the photographing processing module to be electrically connected to the optical-to-electrical conversion chip in response to the electronic device working in a phase of invoking the camera to perform photographing, so that the photographing processing module receives an optical signal collected by the optical-to-electrical conversion chip, and performs processing to obtain image information of the photographed object. In an actual application, the switching control module is connected to an application processor chip of the electronic device, the application processor chip sends a control signal to the switching control module, and the switching control module determines a working state of the electronic device based on the received control chip, so as to control the fingerprint processing module to be electrically connected to the optical-to-electrical conversion chip, or control the photographing processing module to be electrically connected to the optical-to-electrical conversion chip based on the working state of the electronic device. In this way, the optical-to-electrical conversion chip can be applied when the electronic device works in different working states.

According to the electronic device provided in this embodiment of this application, in the display area, transmittance of the first display area is greater than transmittance of the second display area, and the camera is disposed below the first display area, so that an under-screen camera solution is implemented, and a screen-to-body ratio can be improved. A light steering element is disposed below the display panel, and the light steering element can transfer the light reflected by the touch body in the fingerprint recognition area to the optical-to-electrical conversion chip of the camera. That is, in the fingerprint recognition phase, the optical-to-electrical conversion chip in the camera can receive the fingerprint detection light used for fingerprint recognition, so that the fingerprint image information is collected by using the optical-to-electrical conversion chip in the camera, so as to implement the fingerprint recognition. In this embodiment of this application, the optical-to-electrical conversion chip in the camera can be separately applied in a phase in which the camera is invoked to perform photographing and a phase in which the fingerprint recognition is performed, so that hardware integration is improved. An optical-to-electrical conversion chip used for fingerprint recognition does not need to be additionally disposed, so that costs can be reduced. In addition, the optical-to-electrical conversion chip in the camera has relatively high imaging quality and precision, so that the accuracy of fingerprint recognition can be improved.

The light steering element 104 is disposed on a side of the display panel 101 that is back onto a light outlet surface. It can be seen from a top view of FIG. 2 that the light steering element 104 is located between the fingerprint recognition area 121 and the camera 102. The camera 102 is located below the first display area 11, that is, the light steering element 104 is located between the fingerprint recognition area 121 and the first display area 11. The light steering element 104 includes a light inlet side (not shown) and a light outlet side (not shown). The light inlet side is close to the fingerprint recognition area 121, and the light outlet side is close to the camera 102. In this way, it is ensured that the light reflected by the touch body in the fingerprint recognition area in the fingerprint recognition phase can enter the light steering element, and the light is transferred to the optical-to-electrical conversion chip in the camera by using the light steering element.

Specifically, as shown in FIG. 3, the camera 102 further includes a lens group 1022. In the fingerprint recognition phase, the light emitted by the fingerprint recognition light source 103 is emitted to the fingerprint recognition area 121, and the light reflected by the touch body M in the fingerprint recognition area 121 is emitted into the light steering element 104. After being processed by the light steering element 104, the light penetrates the lens group 1022, and then illuminates the optical-to-electrical conversion chip 1021. The lens group 1022 in the camera 102 has a function of converging light, and the fingerprint detection light emitted by the light steering element 104 can be converged on the optical-to-electrical conversion chip after being processed by the lens group 1022, thereby reducing a light loss and ensuring light utilization.

Further, referring to FIG. 3, the light steering element 104 and the lens group 1022 are disposed in a staggered manner. It is ensured that, in the fingerprint recognition phase, the fingerprint detection light that has been processed by the light steering element 104 can illuminate on the optical-to-electrical conversion chip 1021 after being processed by the lens group 1022. In addition, the light steering element 104 is prevented from blocking the light emitted to the camera 102 after the light penetrates the first display area 11, which ensures that imaging performance is not affected when the camera is invoked to perform photographing.

Specifically, in an embodiment, at one end of the light steering element close to the first display area, an edge of the light steering element is flush with an edge of the lens group. In this implementation, the light steering element is close enough to the camera, and a very large part of fingerprint detection light after being processed by the light steering element can illuminate on the optical-to-electrical conversion chip after being processed by the lens group, thereby ensuring accuracy of fingerprint recognition detection. In addition, the setting of the light steering element does not affect imaging performance when the camera is invoked to perform photographing.

Specifically, the display panel in the electronic device provided in this embodiment of this application is an organic light-emitting display panel. FIG. 4 is another schematic cross-sectional diagram across B-B' in FIG. 2. As shown in FIG. 4, the display panel 101 includes a substrate 21, and an array layer 22, a light emitting device layer 23, and a packaging layer 24 that are located on the substrate 21. The light emitting device layer 23 includes a plurality of light emitting devices 40, and the light emitting devices 40 include an anode 41, a light emitting layer 42, and a cathode 43 that are stacked in sequence. The anode 41 is a metal reflection electrode, and the cathode 43 is a transparent electrode. When the light emitting device 40 works, the light emitted by the light emitting layer 42 is emitted by the cathode 43, so as to implement light emitting of the light emitting device 40. The light emitting device layer 23 further includes a pixel definition layer 50, and the pixel definition layer 50 is configured to space adjacent light emitting devices 40. The array layer 22 includes a pixel circuit 221. The pixel circuit 221 is configured to drive the light emitting device 40 to emit light. FIG. 4 shows only one transistor T in the pixel circuit 221. The packaging layer 24 is configured to protect the light emitting device 40 in the light emitting device layer 23, so as to isolate water and oxygen, and ensure a service life of the light emitting device 40. In an embodiment, the packaging layer is thin film packaging, and includes at least one inorganic packaging layer and at least one organic packaging layer. In another embodiment, the packaging layer is rigid packaging, the packaging layer includes a packaging cover, and the packaging cover is bonded and fastened to the array layer by using the frame sealing adhesive.

FIG. 4 further shows a protection cover 105. Optionally, the display panel 101 further includes a touch module. The touch module is located on a side of the packaging layer that is away from a display layer, so that a touch function of the electronic device can be implemented.

In the electronic device provided in this embodiment of this application, transmittance of a first display area of a display panel is greater than transmittance of a second display area. In an embodiment, a size of a light emitting device in the first display area is set to be less than a size of a light emitting device in the second display area, so as to increase the transmittance of the first display area. The size of the light emitting device is understood as an area of a single light emitting device. In another embodiment, a density of the light emitting devices in the first display area is set to be less than a density of the light emitting devices in the second display area, so as to increase the transmittance of the first display area.

In addition, both the transmittance of the first display area and the transmittance of the second display area in this application are transmittance per unit area. In this embodiment of this application, both the first display area and the fingerprint recognition area are some areas in the display area, and the fingerprint recognition area belongs to the second display area. The camera is disposed on a side of the first display area that is back onto a light outlet surface of the first display area, that is, the camera is corresponding to the first display area. When the camera is invoked to perform photographing, ambient light can be received by the camera only after the ambient light penetrates the first display area. In this embodiment of this application, the transmittance of the first display area is set to be greater than the transmittance of the second display area, so as to increase the transmittance of the first display area to ensure the imaging effect when the camera is invoked to perform photographing. The fingerprint recognition area is configured to implement an under-screen optical fingerprint recognition function. In a fingerprint recognition phase, a fingerprint recognition light source is turned on, light emitted by the fingerprint recognition light source is emitted to the fingerprint recognition area, and then reflected by a finger of a user in the fingerprint recognition area and then is emitted back to the display panel. In this case, the fingerprint recognition area also needs to have specific transmittance.

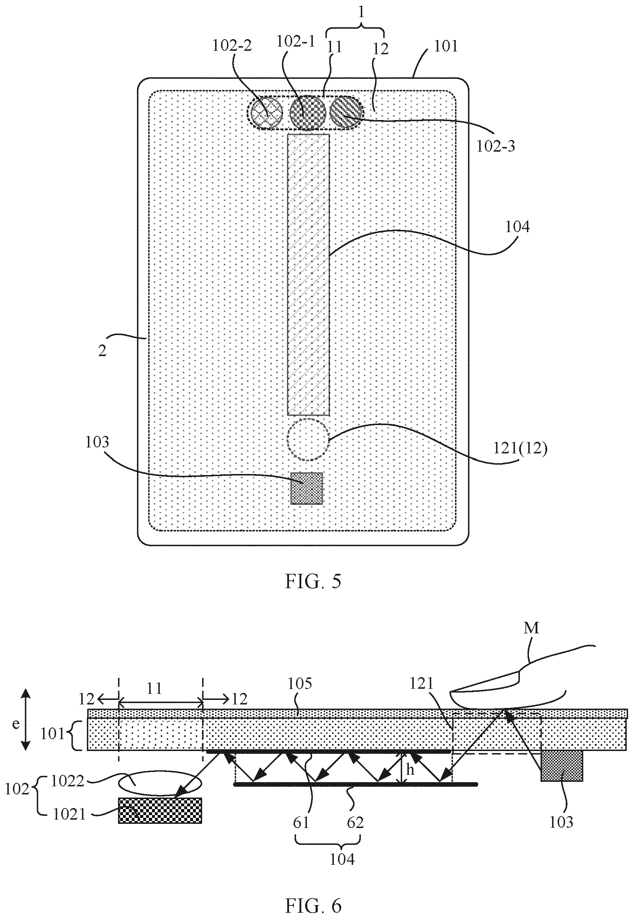

In an embodiment, FIG. 5 is another schematic top view of an electronic device according to an embodiment of this application. As shown in FIG. 5, the electronic device includes three cameras, which are respectively a first camera 102-1, a second camera 102-2, and a third camera 102-3. All the three cameras and the first display area 11 are disposed on a side of the first display area 11 that is back onto the light outlet surface of the display area. In this implementation, the electronic device has three front-facing cameras. Optionally, the first camera 102-1 is a primary camera, the second camera 102-2 is a wide-angle camera, and the third camera 102-3 is a depth camera. The camera, the fingerprint recognition light source, and the light steering element are all located on a back side of the display panel 101. In the fingerprint recognition phase, after a touch or a press of a finger of a user is sensed, the fingerprint recognition light source 103 is turned on, the fingerprint recognition light source 103 emits light to the fingerprint recognition area 121, the finger of the user reflects the light in the fingerprint recognition area 121, and the light steering element 104 can transfer the light reflected by the finger of the user to the optical-to-electrical conversion chip 1021 of the first camera 102-1. Relative positions of the three cameras in FIG. 5 are merely an example.

It should be noted that a quantity of front-facing cameras in the electronic device is not limited in this embodiment of this application. In an embodiment in which the electronic device includes two or three front-facing cameras, or only one of more front-facing cameras is used as a primary camera. In the technical solution of this application, a relative position of the primary camera and the light steering element is set, and light reflected by the touch body in the fingerprint recognition area is transferred to an optical-to-electrical conversion chip of a camera used as the primary camera.

In addition, in embodiments in FIG. 1 and FIG. 5, positions of the first display area and the fingerprint recognition area in the display area are both schematically represented. In practice, the positions of the first display area and the fingerprint recognition area may be correspondingly set based on a specific design requirement.

Specifically, in an embodiment, FIG. 6 is another schematic cross-sectional diagram across A-A' in FIG. 2. As shown in FIG. 6, the light steering element 104 includes a first reflective part 61 and a second reflective part 62 that are disposed opposite to each other, surfaces of the first reflective part 61 and the second reflective part 62 that are opposite to each other are reflective surfaces, the second reflective part 62 is located on a side of the first reflective part 61 that is away from the display panel 101, and in a direction e perpendicular to the display panel 101, and there is a certain distance h between the reflective surface of the first reflective part 61 and the reflective surface of the second reflective part 62. In this embodiment of this application, the value of h is not limited, as long as it is ensured that the light can be reflected and propagated multiple times on the reflective surface of the first reflective part 61 and the reflective surface of the second reflective part 62 after entering the light steering element 104. Optionally, a medium between the first reflective part 61 and the second reflective part 62 is air.

As shown in the figure, the light steering element 104 is at an end close to the fingerprint recognition area 121, and the second reflective part 62 extends out of an edge of the first reflective part 61, so that the reflective surface of the second reflective part 62 can conveniently receive the light reflected by the touch body in the fingerprint recognition area 121, and it is ensured that the fingerprint detection light that is reflected by the touch body and used for fingerprint recognition can be emitted into the light steering element 104, so as to reduce loss of the fingerprint detection light. As shown in FIG. 6, the light steering element 104 is at an end close to the first display area 11, and the first reflective part 61 extends out of an edge of the second reflective part 62. The light reflected by the touch body is first emitted to the second reflective part 62, and then reflected on the reflective surface of the first reflective part 61 and the reflective surface of the second reflective part 62 in the light steering element 104 for multiple times respectively, and finally reflected by the first reflective part 61 and then emitted to the optical-to-electrical conversion chip 1021, so as to ensure that the light can be emitted to the optical-to-electrical conversion chip 1021 after being processed by the light steering element 104 and received by the optical-to-electrical conversion chip 1021.

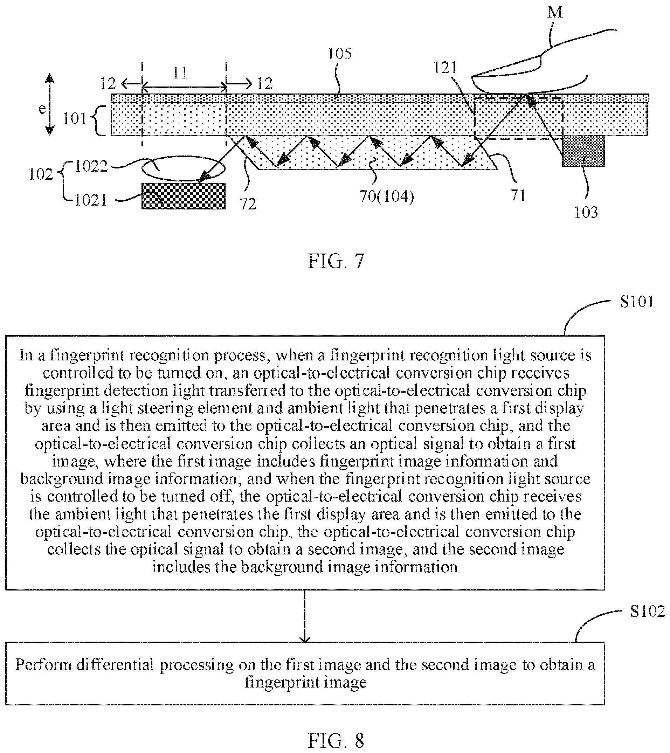

In another embodiment, FIG. 7 is another schematic cross-sectional diagram across A-A' in FIG. 2. As shown in FIG. 7, the light steering element 104 is an optical waveguide 70. The optical waveguide 70 is a media apparatus for guiding light to propagate in the optical waveguide 70. The optical waveguide 70 includes a light inlet surface 71 and a light outlet surface 72. The light inlet surface 71 is located at an end of the optical waveguide 70 that is close to the fingerprint recognition area 121, the light outlet surface 72 is located at an end of the optical waveguide 70 that is close to the first display area 11, and both the light inlet surface 71 and the light outlet surface 72 are oblique surfaces. The light inlet surface 71 faces the fingerprint recognition area 121, so as to ensure that the light reflected by the touch body in the fingerprint recognition area 121 can be emitted into the optical waveguide 70 from the light inlet surface 71. The light outlet surface 72 faces the optical-to-electrical conversion chip 1021, so as to ensure that after being transmitted through the optical waveguide 70, the light can illuminate on the optical-to-electrical conversion chip 1021 after being emitted from the light outlet surface 72, so that the collection of fingerprint image information by using the optical-to-electrical conversion chip of the camera is implemented. In this implementation, the optical waveguide is used as a light steering element, and the optical waveguide is used as an overall structure, so the optical waveguide is more stable in structure, performance of transferring light by the optical waveguide is more reliable, and a light loss of light transmitted in the optical waveguide is small, so as to ensure that a light amount of fingerprint detection light received by the optical-to-electrical conversion chip is large enough, thereby ensuring accuracy of fingerprint detection.

In this embodiment of this application, a camera and a light steering element are disposed on a back side of the display panel. The camera includes an optical-to-electrical conversion chip. In the fingerprint recognition phase, the light steering element can transfer the light reflected by the touch body that touches the fingerprint recognition area to the optical-to-electrical conversion chip of the camera, so as to collect the fingerprint image information by using the optical-to-electrical conversion chip of the camera. Because the transmittance of the first display area corresponding to an under-screen camera is relatively high, in the fingerprint recognition phase, the optical-to-electrical conversion chip of the camera not only receives the fingerprint detection light that is transmitted by the light steering element and used for fingerprint recognition, but also receives ambient light that is transmitted to the optical-to-electrical conversion chip after penetrating the first display area. In this case, ambient light causes interference to the collection of the fingerprint image. Based on this, an embodiment of this application further provides a fingerprint recognition method, which can be applied to the electronic device provided in embodiments of this application, to eliminate interference caused by ambient light to fingerprint detection, and improve the accuracy of fingerprint recognition.

FIG. 8 is a flowchart of a fingerprint recognition method according to an embodiment of this application. As shown in FIG. 8, the fingerprint recognition method includes:

Step S101: In a fingerprint recognition process, when a fingerprint recognition light source is controlled to be turned on, an optical-to-electrical conversion chip receives fingerprint detection light transferred to the optical-to-electrical conversion chip by using a light steering element and ambient light that penetrates a first display area and is then emitted to the optical-to-electrical conversion chip, and the optical-to-electrical conversion chip collects an optical signal to obtain a first image, where the first image includes fingerprint image information and background image information, and the fingerprint image information is obtained by the optical-to-electrical conversion chip by receiving the fingerprint detection light transferred to the optical-to-electrical conversion chip by using the light steering element, and the background image information is obtained by the optical-to-electrical conversion chip by receiving the ambient light that penetrates the first display area and is emitted to the optical-to-electrical conversion chip; and when the fingerprint recognition light source is controlled to be turned off, the optical-to-electrical conversion chip receives only the ambient light that penetrates the first display area and is then emitted to the optical-to-electrical conversion chip, the optical-to-electrical conversion chip collects the optical signal to obtain a second image, and the second image includes only the background image information. A sequence of turning on and turning off the fingerprint recognition light source is not limited.

Step S102: Perform differential processing on the first image and the second image to obtain a fingerprint image.

When fingerprint recognition is performed once, the fingerprint recognition light source is controlled to be turned on and turned off once. When the fingerprint recognition light source is turned on, the optical-to-electrical conversion chip receives the fingerprint detection light transmitted to the optical-to-electrical conversion chip by using the light steering element and the ambient light that is transmitted to the optical-to-electrical conversion chip after penetrating the first display area, so the image information collected by the optical-to-electrical conversion chip includes the fingerprint image information and the background image information. When the fingerprint recognition light source is turned off, the optical-to-electrical conversion chip receives only the ambient light that penetrates the first display area and is then emitted to the optical-to-electrical conversion chip, so the image signal collected by the optical-to-electrical conversion chip includes only the background image information. Differential processing is performed on the first image and the second image to obtain a fingerprint image, so that interference caused by ambient light to fingerprint detection can be eliminated. Then, processing such as feature extraction, and recognition and comparison is performed on the fingerprint image, so that accuracy of fingerprint recognition can be improved.

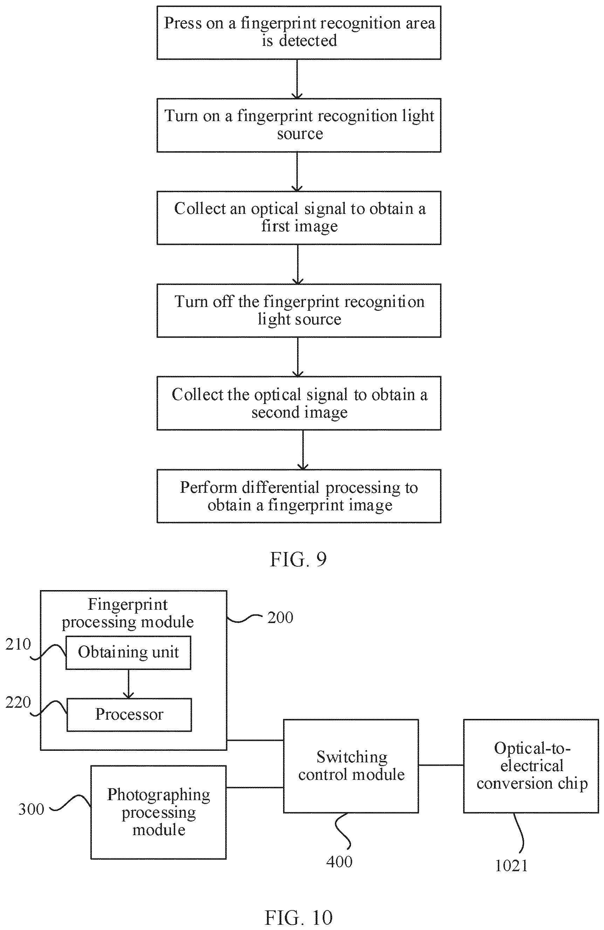

Specifically, the electronic device provided in this embodiment of this application further includes a pressure sensor. The pressure sensor is configured to detect a pressure status of the fingerprint recognition area, to determine whether the user performs a touch or press operation on the fingerprint recognition area, to trigger fingerprint detection. When it is detected that there is a touch or press operation on the fingerprint recognition area, a working phase of fingerprint recognition detection is entered. FIG. 9 is a flowchart of fingerprint recognition working of an electronic device according to an embodiment of this application. As shown in FIG. 9, press detection is first performed on the fingerprint recognition area. When it is detected that there is a press in the fingerprint recognition area, a fingerprint recognition light source is controlled to be turned on. Then, an optical-to-electrical conversion unit in the camera is controlled to collect an optical signal to obtain a first image. Then, the fingerprint recognition light source is controlled to be turned off. The optical-to-electrical conversion unit in the camera collects an optical signal to obtain a second image. Then, differential processing is performed on the first image and the second image to obtain a fingerprint image. Subsequently, processing such as feature extraction, and recognition and comparison can be performed on the fingerprint image to implement fingerprint recognition.

Further, FIG. 10 is a schematic modular diagram of an electronic device according to an embodiment of this application. As shown in FIG. 10, the electronic device provided in this embodiment of this application further includes a fingerprint processing module 200, a photographing processing module 300, and a switching control module 400. The switching control module is configured to control the fingerprint processing module to be electrically connected to the optical-to-electrical conversion chip in response to the electronic device working in a fingerprint recognition phase, and is further configured to control the photographing processing module to be electrically connected to the optical-to-electrical conversion chip in response to the electronic device working in a phase of invoking a camera to perform photographing. The fingerprint processing module 200 is configured to: in a fingerprint recognition phase, receive image information obtained after the optical-to-electrical conversion chip 1021 receives light, to obtain a fingerprint image, and then process the fingerprint image to implement fingerprint recognition. The photographing processing module 300 is configured to: when the camera 102 is invoked, receive image information of a photographed object that is obtained after the optical-to-electrical conversion chip 1021 receives light, and perform imaging based on the image information.

The fingerprint processing module 200 includes an obtaining unit 210 and a processor 220.

In a fingerprint recognition process, the obtaining unit 210 is configured to: when a fingerprint recognition light source is turned on, obtain a first image based on an optical signal collected by an optical-to-electrical conversion chip, where the first image includes fingerprint image information and background image information, the fingerprint image information is obtained by the optical-to-electrical conversion chip by receiving fingerprint detection light transmitted to the optical-to-electrical conversion chip 1021 by using a light steering element, and the background image information is obtained by the optical-to-electrical conversion chip by receiving ambient light that penetrates a first display area and is emitted to the optical-to-electrical conversion chip 1021. The obtaining unit 210 is further configured to: when the fingerprint recognition light source is turned off, obtain a second image based on the optical signal collected by the optical-to-electrical conversion chip 1021, where the second image includes the background image information; and send the first image and the second image to the processor 220.

The processor 220 is configured to perform differential processing on the first image and the second image to obtain a fingerprint image, and the processor 220 is further configured to perform processing such as feature extraction, and recognition and comparison on the fingerprint image to implement fingerprint recognition.

When the electronic device is driven to work, in a fingerprint recognition phase, the optical-to-electrical conversion chip 1021 is controlled to be electrically connected to the fingerprint processing module 200, so that the fingerprint processing module 200 receives the image information obtained by the optical-to-electrical conversion chip 1021; and in a phase of invoking a camera to perform photographing, the optical-to-electrical conversion chip 1021 is controlled to be electrically connected to the photographing processing module 300, so that the photographing processing module 300 receives the image information of a photographed object obtained by the optical-to-electrical conversion chip 1021. In this way, the optical-to-electrical conversion chip in the camera can be separately applied in a phase in which the camera is invoked to perform photographing and a phase in which the fingerprint recognition is performed, so that hardware integration is improved. An optical-to-electrical conversion chip used for fingerprint recognition does not need to be additionally disposed, so that costs can be reduced. In addition, the optical-to-electrical conversion chip in the camera has relatively high imaging quality and precision, so that accuracy of fingerprint recognition can be improved.

The electronic device provided in embodiments of this application may be, for example, an electronic device like a mobile phone, a tablet computer, a notebook computer, an electronic book, or a television.

The foregoing descriptions are merely example embodiments of the present invention, but are not intended to limit the present invention. Any modification, equivalent replacement, or improvement made within the spirit and principle of the present invention should fall within the protection scope of the present invention.

Finally, it should be noted that the foregoing embodiments are merely intended for describing the technical solutions of the present invention, but not for limiting the present invention. Although the present invention is described in detail with reference to the foregoing embodiments, persons of ordinary skill in the art should understand that they may still make modifications to the technical solutions described in the foregoing embodiments or make equivalent replacements to some or all technical features thereof, without departing from the scope of the technical solutions of embodiments of the present invention.

## Claims

1. An electronic device, wherein the electronic device comprises a display panel, a camera, a fingerprint recognition light source, and a light steering element, wherein
the display panel comprises a first display area and a second display area, transmittance of the first display area is greater than transmittance of the second display area, and the second display area comprises a fingerprint recognition area;
the camera, the fingerprint recognition light source, and the light steering element are all located on a side of the display panel that is back onto a light outlet surface of the display panel, wherein
the camera comprises an optical-to-electrical conversion chip, and the camera is disposed on a side of the first display area that is back onto a light outlet surface of the first display area;
the fingerprint recognition light source is configured to emit light to the fingerprint recognition area in a fingerprint recognition phase; and
the light steering element is configured to transfer light reflected by a touch body that presses the fingerprint recognition area to the optical-to-electrical conversion chip in the fingerprint recognition phase.

2. The electronic device according to claim 1, wherein the electronic device further comprises a fingerprint processing module, a photographing processing module, and a switching control module, wherein
the switching control module is configured to control the fingerprint processing module to be electrically connected to the optical-to-electrical conversion chip in response to the electronic device working in the fingerprint recognition phase; the switching control module is further configured to control the photographing processing module to be electrically connected to the optical-to-electrical conversion chip in response to the electronic device working in a phase of invoking the camera to perform photographing;
the fingerprint processing module is configured to receive image information obtained after the optical-to-electrical conversion chip receives light, and perform fingerprint recognition; and
the photographing processing module is configured to receive the image information obtained after the optical-to-electrical conversion chip receives light, and perform imaging on a photographed object.

3. The electronic device according to claim 2, wherein
the fingerprint processing module comprises an obtaining unit and a processor, wherein
in a fingerprint recognition process, the obtaining unit is configured to: when the fingerprint recognition light source is turned on, obtain a first image based on an optical signal collected by the optical-to-electrical conversion chip, and send the first image to the processor, wherein the first image comprises fingerprint image information and background image information; and when the fingerprint recognition light source is turned off, obtain a second image based on an optical signal collected by the optical-to-electrical conversion chip, and send the second image to the processor, wherein the second image comprises background image information; and
the processor is configured to perform differential processing on the first image and the second image to obtain a fingerprint image.

4. The electronic device according to claim 1, wherein
the camera further comprises a lens group, and the lens group is located on a side of the optical-to-electrical conversion chip that is close to the display panel.

5. The electronic device according to claim 4, wherein
the light steering element and the lens group are disposed in a staggered manner.

6. The electronic device according to claim 1, wherein
the light steering element is located between the fingerprint recognition area and the first display area.

7. The electronic device according to claim 1, wherein
the light steering element comprises a first reflective part and a second reflective part that are disposed opposite to each other, surfaces of the first reflective part and the second reflective part that are opposite to each other are reflective surfaces, the second reflective part is on a side of the first reflective part that is away from the display panel, and there is a certain distance between the reflective surface of the first reflective part and the reflective surface of the second reflective part.

8. The electronic device according to claim 7, wherein
at one end that is close to the fingerprint recognition area, the second reflective part extends out of an edge of the first reflective part; and
at one end that is close to the first display area, the first reflective part extends out of an edge of the second reflective part.

9. The electronic device according to claim 1, wherein
the light steering element is an optical waveguide, and the optical waveguide comprises a light inlet surface and a light outlet surface, wherein
the light inlet surface is located at one end that is close to the fingerprint recognition area, and the light inlet surface faces the fingerprint recognition area; and
the light outlet surface is located at one end that is close to the first display area, and the light outlet surface faces the optical-to-electrical conversion chip.

10. The electronic device according to claim 1, wherein
the display panel comprises a substrate and a light emitting device layer, and the light emitting device layer is located on a side of the substrate that is away from the camera, wherein the light emitting device layer comprises a plurality of light emitting devices; and
a density of the light emitting devices in the first display area is less than a density of the light emitting devices in the second display area.
